(19) Europäisches Patentamt
European Patent Office
Office européen des brevets

(11) **EP 3 524 993 B1**

(12) **EUROPÄISCHE PATENTSCHRIFT**

(45) Veröffentlichungstag und Bekanntmachung des Hinweises auf die Patenterteilung:
**18.12.2019 Patentblatt 2019/51**

(51) Int Cl.:
***G01R 33/30*** *(2006.01)*

(21) Anmeldenummer: **19155664.6**

(22) Anmeldetag: **06.02.2019**

(54) **NMR-MAS-PROBENKOPF MIT VERSCHWENKBAREM STATOR**

NMR-MAS-SAMPLE HEAD WITH PIVOTABLE STATOR

TÊTE D'ÉCHANTILLON POUR UNDE SONDE RMN À L'ANGLE MAGIQUE À STATOR PIVOTANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.02.2018 DE 102018202002**

(43) Veröffentlichungstag der Anmeldung:
**14.08.2019 Patentblatt 2019/33**

(73) Patentinhaber: **Bruker BioSpin GmbH
76287 Rheinstetten (DE)**

(72) Erfinder:
  • **Krahn, Alexander
    76137 Karlsruhe (DE)**
  • **Osen, David
    76275 Ettlingen (DE)**
  • **Purea, Armin
    76669 Bad Schönborn (DE)**
  • **Mayer, Markus
    8625 Gossau (CH)**
  • **Meister, Roger
    8132 Hinteregg (CH)**

(74) Vertreter: **Kohler Schmid Möbus Patentanwälte Partnerschaftsgesellschaft mbB
Gropiusplatz 10
70563 Stuttgart (DE)**

(56) Entgegenhaltungen:
**DE-B3-102013 201 110    DE-B3-102014 201 076
US-B2- 7 915 893**

**Beschreibung**

Die Erfindung betrifft einen Probenkopf einer Kernspinresonanz(=NMR)-Magic-Angle-Spinning(=MAS)-Anordnung mit einem MAS-Stator zur Aufnahme eines MAS-Rotors, welcher in einer Messposition, in der die Zylinderachse des MAS-Rotors im magischen Winkel zu einem $B_0$-Feld der NMR-MAS-Anordnung steht, in Rotation versetzt werden kann, wobei der MAS Stator eine Öffnung zur Einführung eines MAS-Rotors aufweist, wobei der MAS-Stator im NMR-MAS-Probenkopf derart angeordnet ist, dass er zwischen der Messposition und einer Beladeposition, in welcher ein MAS-Rotor in den MAS-Stator eingeführt werden kann, verschwenkbar ist.

Ein solcher NMR-MAS-Probenkopf ist aus der DE 10 2013 201 110 B3 (= Referenz [1]) bekannt.

Die US 2010 / 0 097 060 A1 (= Referenz [5]) beschreibt einen gattungsgemäßen Probenkopf, der eine Detektionsvorrichtung aufweist, die es ermöglicht, berührungslos von außen zu erkennen, ob der MAS-Stator aktuell mit einem MAS-Rotor bestückt ist oder nicht, wobei die Detektionsvorrichtung eine Lichtquelle aufweist, aus welcher Licht in ein unteres Ende eines Lichtleiters eingeleitet werden kann, und wobei der MAS-Stator eine erste Bohrung aufweist, in der der Lichtleiter positioniert ist.

Hintergrund der Erfindung

Die NMR-Spektroskopie stellt ein leistungsfähiges Verfahren der instrumentellen Analytik dar. Dabei werden in eine Messprobe, die sich in einem starken, statischen Magnetfeld befindet, wodurch es zur Ausrichtung von Kernspins in der Messsubstanz kommt, HF(=Hochfrequenz)-Pulse eingestrahlt, und die HF-Reaktion der Messprobe wird vermessen. Sodann werden die Informationen integral über einen gewissen Bereich der Messprobe, das sogenannte aktive Volumen, gewonnen und zur Bestimmung der chemischen Zusammensetzung ausgewertet.

Zur Verringerung von Linienverbreiterungen aufgrund anisotroper Wechselwirkungen ist es bekannt, eine NMR-Probe während der spektroskopischen Vermessung unter dem so genannten "Magischen Winkel" von $\arctan\sqrt{2} \approx 54{,}74°$ gegenüber dem statischen Magnetfeld verkippt mit hoher Frequenz (typisch einige kHz) rotieren zu lassen. Dazu wird die Probe in einen MAS-Rotor gefüllt. MAS-Rotoren sind in der Regel einseitig offene, zylindrische Röhrchen, die mit einer Kappe verschlossen sind, wobei die Kappe mit Flügelelementen versehen ist. Der MAS-Rotor wird in einem MAS-Stator angeordnet, und mit Gasdruck wird der MAS-Rotor über die Flügelelemente für die Rotation angetrieben.

Die EP 3 093 679 B1 (= Referenz [2]) beschreibt einen NMR-MAS-Probenkopf mit allen körperlichen Bestandteilen des eingangs definierten gattungsgemäßen Probenkopfs, der allerdings -entgegen der Lehre von Referenz [1]- *keine Verschwenkbarkeit* aufweist. Dadurch ist die Be- und Entladung des MAS-Stators mit einem eine neue NMR-Probe enthaltenden MAS-Rotor vor und nach jeder NMR-Messung jedes Mal relativ kompliziert, da der Stator nicht in eine optimierte Beladungsposition zum Einführen des Rotors verbracht werden kann, bei in der Regel die Aufnahmeöffnung parallel zur z-Achse des NMR-Magnetsystems steht, sondern immer in einer dazu schrägen Lage verbleibt.

Auch in der DE 10 2014 201 076 B3 (= Referenz [3]) ist ein NMR-MAS-Probenkopf beschrieben, bei dem der MAS-Stator ebenfalls *nicht verschwenkbar* aufgebaut ist. Darüber hinaus offenbart Referenz [3] aber auch eine Ausführungsform dieses Probenkopfs, bei welcher eine zusätzliche Vorrichtung vorhanden ist, die es ermöglicht, von außen zu erkennen, ob ein Transportbehälter aktuell mit einem NMR MAS-Rotor bestückt ist. Dazu wird ein zusätzliches mechanisches Bauteil durch den in den Transportbehälter eingebrachten MAS-Rotor derart verschoben, dass von außen am Transportbehälter von Auge oder mittels Sensoren erkannt werden kann, ob der Transportbehälter mit einem MAS-Rotor bestückt ist oder nicht.

In US 7,915,893 B2 (= Referenz [4]) wird ein NMR-MAS-Probenkopf für eine CryoMAS Probe offenbart, bei dem der MAS-Stator zwar wiederum *nicht verschwenkbar* im Probenkopf angeordnet ist, bei dem aber eine berührungslose optische Messung der Rotationsfrequenz des MAS-Rotors im Betriebszustand möglich ist.

Im Gegensatz zu den drei oben diskutierten Referenzen [2] bis [4] offenbart die eingangs zitierte DE 10 2013 201 110 B3 (= Referenz [1]) einen -bezüglich der vorliegenden Erfindung gattungsgemäßen- NMR-MAS-Probenkopf, bei welchem der MAS-Stator im Probenkopf *verschwenkbar* gelagert ist, um die Kurve in der Bewegung des MAS-Rotors beim Einbringen in den MAS-Stator und umgekehrt zu verringern. Zum Verbringen soll der MAS-Stator dann um das magnetische Zentrum verschwenkt werden. Damit soll dieser Probenkopf noch kompakter ausgeführt werden können.

Dieser gattungsgemäße Probenkopf mit den eingangs definierten Merkmalen hat jedoch immer noch störende Nachteile:

So ist es zum einen nicht möglich, eine mechanische Vorrichtung zur Erkennung des Beladungszustands des MAS-Stators anzubringen, wie sie in Referenz [3] vorgeschlagen wird. Diese würde nämlich eine Verschwenkung des MAS-Stators über einen relativ großen Winkel zwischen einer Messposition und einer Beladeposition -wie in Referenz [1] vorgeschlagen- vermutlich nicht unbeschädigt überstehen, sicherlich jedenfalls nicht nach einer Vielzahl von Verschwenkungen.

Die -gewünschte- Verschwenkbarkeit des MAS-Stators steht aber auch einer Frequenzdetektion des im Betriebszustand während einer NMR-Messung rotierenden MAS-Rotors entgegen, wie sie in Referenz [4] vorgeschlagen wird. Ein feststehender Lichtleiter würde an seinem MAS-Stator-seitigen Ende -zumindest nach mehreren Verschwenkungen des MAS-Stators- unweigerlich brechen. Das gleiche würde vermutlich auch bei Verwendung eines Drahtes anstelle des Lichtleiters für eine elektrische statt einer optischen Frequenzdetektion passieren.

Auch eine Beladungserkennung gemäß Referenz [3], bei der aber statt der dort vorgeschlagenen mechanischen Vorrichtung eine elektrische Zuführung oder ein optischer Lichtleiter gemäß Referenz [4] zum MAS-Stator verwendet werden würde, wäre aus den oben genannten Gründen nur bei einem nichtverschwenkbaren MAS-Stator möglich, weil ansonsten mit einer hohen Bruchgefahr der Leiterelemente am bewegten MAS-Stator gerechnet werden müsste.

Dennoch wäre es wünschenswert, eine zumindest optische Detektionsvorrichtung für MAS Probenköpfe mit verschwenkbarem MAS-Stator bereitzustellen, die diese Nachteile nicht aufweisen, so dass etwa ein -üblicherweise relativ spröder- Lichtleiter auch im Dauerbetrieb mit einem verschwenkbaren MAS-Stator keiner bedrohlichen mechanischen Belastung und damit hoher Bruchgefahr ausgesetzt ist.

Aufgabe der Erfindung

Der vorliegenden Erfindung liegt demgegenüber die Aufgabe zugrunde, einen NMR-MAS-Probenkopf der eingangs definierten Art mit verschwenkbarem MAS-Stator zur Verfügung zu stellen, der durch möglichst einfache technische Maßnahmen so modifiziert ist, dass keine mechanischen Verschiebungen und auch keine zusätzlichen bewegten Bauteile für eine berührungsfreie, sichere Erkennung der aktuellen Bestückung erforderlich sind, wobei zudem aber gerade die Verschwenkbarkeit des MAS-Stators zwischen der Messposition und der Beladeposition, in welcher ein MAS-Rotor in den MAS-Stator eingeführt werden kann, in einem möglichst großen Winkelbereich erhalten bleiben soll.

Kurze Beschreibung der Erfindung

Diese komplexe Aufgabe wird auf ebenso überraschend einfache wie wirkungsvolle Weise dadurch gelöst, dass ein gattungsgemäßer NMR-MAS-Probenkopf mit den eingangs definierten Merkmalen eine Detektionsvorrichtung aufweist, die es ermöglicht, berührungslos von außen zu erkennen, ob der MAS-Stator aktuell mit einem MAS-Rotor bestückt ist oder nicht, dass diese Detektionsvorrichtung eine Lichtquelle aufweist, aus welcher Licht in ein unteres Ende eines Lichtleiters eingeleitet werden kann, und dass der MAS-Stator eine erste Bohrung aufweist, in der ein erster Lichtleiter-Stummel so positioniert ist, dass er in der Beladeposition des MAS-Stators eine optische Verbindung zwischen einem im MAS-Stator eingeführten MAS-Rotor und einem dem unteren Ende entgegengesetzten oberen Ende des Lichtleiters herstellt.

Der erfindungsgemäße Probenkopf weist also im Gegensatz zur bisher üblichen Ausführung eine spezielle optische Sensorik auf, die eine sichere, berührungsfreie Anwesenheitsdetektion des MAS-Rotors im MAS-Stator ermöglicht, ohne dass dazu mechanisch bewegte Bauteile erforderlich sind.

Bei Verwendung eines derartigen optischen Leiters sind die Signale besonders störungsunempfindlich, insbesondere gegen die bei der NMR unerlässlichen starken Magnetfelder.

Die Verschwenkbarkeit des MAS-Stators in einem nennenswert großen Winkelbereich ermöglicht den Ein- und Auswurf auch größerer MAS-Rotoren. In Kombination mit einem durchgehenden Lichtleiter würde dieser jedoch durch die Verschwenkung mechanisch stark belastet und bräche nach vermutlich bereits wenigen Bewegungen, jedenfalls schon nach kurzer Betriebsdauer. Durch die erfindungsgemäße -körperlich-mechanische-Teilung des Lichtleiters wird dieses Problem aber beim erfindungsgemäßen Probenkopf gelöst.

Durch diese erfindungsgemäße Auftrennung des Lichtpfades in einen -im Wesentlichen unbewegten-Lichtleiter sowie in den -zusammen mit dem MAS-Stator verschwenkbaren, bisher unbekannten- Lichtleiter-Stummel, wobei zwischen diesen beiden optischen Bauelementen lediglich eine optische, aber keine mechanische Verbindung besteht, wird es problemlos und ohne größeren technischen Aufwand ermöglicht, den Stator in einem relativ großen Winkelbereich zu bewegen, ohne dass dabei der Lichtleiter Schaden nehmen kann. Beispielsweise mit einer elektrischen Messung durch Leiterdrähte wäre eine derartige Detektion gar nicht möglich, weil nach einer körperlichen Auftrennung von elektrischen Leiterelementen gar kein Strom mehr zwischen den einzelnen aufgetrennten Leiterteilen fließen könnte.

Aufgrund der unterbrochenen Lichtleiterverbindung wird nun selbst bei großwinkliger Verschwenkung des MAS-Stators kein mechanischer Stress auf die Lichtleiterfaser ausgeübt, so dass bei einem Probenwechsel die Gefahr eines Bruchs der Faser ausgeschlossen werden kann. In der Einwurf- und Auswurfposition kann über den Lichtleiter durch Änderung der reflektierten Helligkeit die Rotationsrate, sowie auch der Ein- /und Auswurf detektiert werden. Eine Unterscheidung der beiden Betriebsfälle kann beispielsweise über eine Bewertung des zeitlichen Amplitudenverlaufs des reflektierten Signals getroffen werden.

Gerade aufgrund der durch die Erfindung eröffneten Möglichkeiten einer ohne weiteres automatisierbaren Detektion der aktuellen Bestückungssituation des Systems wird dem Benutzer ein besonders wirkungsvolles Werkzeug an die Hand gegeben. Diese Möglichkeit der Detektion ist auch ein Sicherheitsmerkmal, denn sie gibt dem Benutzer den Hinweis, ob ein Rotor sich beim Beladen nicht verklemmt hat, was beim Verschwenken des Stators zu Schäden am Rotor, was mit Verlust der Messprobe einhergeht, oder am Stator selbst führen kann.

An dieser Stelle sei ausdrücklich darauf hingewiesen, dass sich die Vorteile der Erfindung nicht nur bei vertikalen NMR-Spektrometern, sondern ebenso auch bei NMR-Systemen mit horizontaler oder schräg liegender z-Achse erzielen lassen. Die angegebenen axialen Positionen müssen dann nicht mehr notwendig "oberhalb" beziehungsweise "unterhalb" des NMR-Magnetsystems liegen, sondern gegebenenfalls auch "rechts" oder "links" neben demselben. Jedenfalls spielt die Schwerkraft bei der Wirkungsweise der vorliegenden Erfindung eine eher untergeordnete Rolle.

Bevorzugte Ausführungsformen der Erfindung

Bei einer ganz besonders bevorzugten Ausführungsform des erfindungsgemäßen Probenkopfs weist die Detektionsvorrichtung einen lichtempfindlichen Detektor auf, welcher durch den MAS-Rotor reflektiertes Licht aus dem unteren Ende des Lichtleiters detektieren kann. Diese Art der Detektion ermöglicht eine "Erkennung" des Rotors, und zwar sowohl seiner Anwesenheit als einmalige Änderung wie auch der Rotationsbewegung als periodischer Wechsel.

Vorteilhafte Weiterbildungen dieser Ausführungsformen zeichnen sich dadurch aus, dass eine Auswerteeinheit vorgesehen ist, welche die Signale des lichtempfindlichen Detektors auswerten und damit feststellen kann, ob der MAS-Stator aktuell mit einem MAS-Rotor bestückt ist oder nicht. Mit der Anwesenheitsdetektion kann sichergestellt werden, dass der Rotor korrekt in Position ist, wenn der Stator in die NMR-Mess-Position unter dem MAS-Winkel gefahren wird. Ansonsten bestünde die Gefahr einer mechanischen Beschädigung, wenn sich beispielsweise der Rotor in einer Zwischenposition verkantet.

Weitere, besonders bevorzugte Ausführungsformen des erfindungsgemäßen Probenkopfs sehen vor, dass der verschwenkbare MAS-Stator derart mechanisch gehaltert ist, dass er aus der Messposition in die Beladeposition um einen Verschwenkwinkel $\gamma \geq 3°$, vorzugsweise $\gamma > 35°$, bewegt werden kann. Damit eröffnet sich auf einfache Weise die Möglichkeit, den Rotor einerseits zu beladen, andererseits im magischen Winkel rotierend zu betreiben.

Bei einer Klasse von vorteilhaften Ausführungsformen des erfindungsgemäßen Probenkopfes weist der MAS-Stator eine zweite Bohrung auf, in der ein zweiter Lichtleiter-Stummel so positioniert ist, dass er in der Messposition des MAS-Stators jedes Mal eine optische Verbindung zwischen einer optischen Markierung im MAS-Stator rotierenden MAS-Rotors und dem oberen Ende des Lichtleiters herstellt, wenn die optische Markierung des rotierenden MAS-Rotors am oberen Ende des Lichtleiters vorbeibewegt wird. Diese Maßnahme führt ebenfalls zu der Möglichkeit, die Rotation auch im magischen Winkel zu detektieren.

Vorteilhafte Weiterbildungen dieser Klasse von Ausführungsformen zeichnen sich dadurch aus, dass der lichtempfindliche Detektor der Detektionsvorrichtung durch die optische Markierung des MAS-Rotors reflektiertes, am unteren Ende des Lichtleiters ankommendes Licht detektieren kann, und dass die Auswerteeinheit die Signale des lichtempfindlichen Detektors auswerten und aufgrund ihrer periodischen Zeitabhängigkeit feststellen kann, mit welcher Frequenz der MAS-Rotor aktuell rotiert. Damit wird besonders eine einfache Detektion der Rotationsfrequenz ermöglicht.

Eine weitere bevorzugte Weiterbildung ist dadurch gekennzeichnet, dass die beiden Lichtleiter-Stummel eine zylindrische Form haben und ihre Zylinderachsen in einem Winkel zueinander orientiert sind, der vorzugsweise dem maximalen Verschwenkwinkel $\gamma$ des MAS-Stators aus der Messposition in die Beladeposition entspricht. Eine solche zylindrische Form ist relativ einfach herstellbar. Damit ergibt sich dann auch die Transmissionsfähigkeit sowohl in Belade- als auch Messposition.

In der Praxis bewährt sich besonders eine weitere Klasse von Ausführungsformen des erfindungsgemäßen Probenkopfs, die sich dadurch auszeichnet, dass die Lichtleiter-Stummel eine zylindrische Form haben, wobei ihr im beladenen Betriebszustand dem MAS-Rotor zugewandtes Ende rechtwinklig zu ihrer Zylinderachse und ihr dem Lichtleiter zugewandtes anderes Ende unter einem Winkel $\alpha$ schräg zu ihrer Zylinderachse plan geschliffen ist. Dies ermöglicht eine besondere Einfachheit der Konstruktion, und da beide Stummel gleich dimensioniert sind. So besteht dann auch keine Verwechslungsgefahr beim Zusammenbau. Es muss lediglich darauf geachtet werden, das schiefe Ende nach außen zu platzieren und die Drehung richtig zu wählen.

Bei vorteilhaften Weiterbildungen dieser Klasse von Ausführungsformen ist der Winkel $\alpha$ abhängig vom Brechungsindex des Lichtleiter-Stummels sowie vorzugsweise vom maximalen Verschwenkwinkel $\gamma$ des MAS-Stators aus der Messposition in die Beladeposition gewählt. Damit wird eine Auslegung des Stummels im Hinblick auf eine optimale Transmission ermöglicht.

Vorzugsweise sollte die Herstellungstoleranz des Winkels $\alpha$ höchstens 5% betragen. Insbesondere sollten die den Winkel $\alpha$ definierenden Flächen auf dem Lichtleiter-Stummel mit einer Fertigungstoleranz von etwa $\pm 30\mu m$ hergestellt werden. Wenn nämlich die erfindungsgemäße Methode eine engere Toleranz erfordern würde, dann wäre dies insofern ungünstig, als dass beispielsweise Herstellungstoleranzen und Temperaturausdehnung weit kritischere Auswirkungen hätten, die Methode also weit weniger robust wäre. Dies lässt sich aber mit der oben vorgeschlagenen Maßnahme leicht vermeiden.

Ausführungsformen der oben beschriebenen Klassen können bei Bedarf übrigens auch miteinander kombiniert werden.

Spezielle Weiterbildungen beider obigen Klassen von Ausführungsformen zeichnen sich dadurch aus, dass im beladenen Betriebszustand dem MAS-Rotor die Zylinderachsen der beiden Lichtleiter-Stummel jeweils in einem unterschiedlichen Winkel zur Zylinderachse des MAS-Rotors im MAS-Stator angeordnet sind. Diese Maßnahme kann erforderlich werden, damit in beiden Fällen Licht vom festen Ende des Lichtleiters auf die Rotorfase gelangen kann.

Vorteilhaft ist auch eine Ausführungsform des erfindungsgemäßen Probenkopfs, bei welcher das Material der Lichtleiter-Stummel so gewählt ist, dass es in einem Temperaturbereich zwischen 100K und 470K einen festen Aggregatszustand zeigt und einen Wärmeausdehnungskoeffizienten von $2000*10^{-6}$/K, vorzugsweise von $100*10^{-6}$/K, nicht übersteigt. Eine Berechnung beziehungsweise Auslegung gilt dann über den spezifizierten Temperaturbereich, ansonsten könnte eine wärmebedingte mechanische Deformation zu einer ungenauen oder gar falschen Detektion führen.

Außerdem sollte das Material der Lichtleiter-Stummel so gewählt werden, dass im Wellenlängenbereich des verwendeten Lichts lediglich eine geringe optische Dämpfung vorhanden ist, und dass der Brechungsindex < 2 beträgt, damit keine übermäßige Reflexion auftritt.

Weitere bevorzugte Ausführungsformen des erfindungsgemäßen Probenkopfs sind dadurch gekennzeichnet, dass die Drehachse für die Verschwenkung des MAS-Stators durch den Mittelpunkt des MAS-Stators verläuft, und dass sich der Mittelpunkt des MAS-Rotors zentral im Bo-Feld der NMR-MAS-Anordnung befindet. Damit ergibt sich ein minimierter geringster Raumbedarf sowie eine optimale Position im Magnetfeld.

Bei vorteilhaften Ausführungsformen der Erfindung ist zwischen dem oberen Ende des Lichtleiters und dem ihm zugewandten Ende des ersten Lichtleiter-Stummels in der Beladeposition des MAS-Stators sowie dem ihm zugewandten Ende des zweiten Lichtleiter-Stummels in der Messposition des MAS-Stators jeweils ein Luftspalt vorhanden, dessen Größe vorzugsweise zwischen 0,1mm und 2mm beträgt. Dieser Spalt ermöglicht eigentlich erst die erfindungsgemäße mechanische Trennung des Lichtleiters, wodurch der Verschleiß der Lichtleiterteile deutlich reduziert wird. Der Luftspalt sollte jedenfalls möglichst klein gewählt werden, damit die maximale Lichtmenge übertragen werden kann. Das optische Signal vom Rotor zur Detektionseinheit kann somit von beiden Positionen des Stators auf ein und denselben Lichtleiter übertragen werden.

Der Lichtleiter kann ganz einfach an einem Tragegerüst (= "Backbone") des Probenkopfes befestigt sein, welches üblicherweise auch von einer HF-Abschirmung umschlossen ist.

Des Weiteren kann die Detektionsvorrichtung mit der Lichtquelle, dem lichtempfindlichen Detektor sowie der Auswerteeinheit in einem Fußkasten des Probenkopfes untergebracht sein.

Die vorliegende Erfindung entfaltet besondere Vorteile gerade bei größeren NMR-Messproben, insbesondere wenn dass der MAS-Stator zur Aufnahme eines MAS-Rotors mit einem Durchmesser > 2,5mm, vorzugsweise ≥ 3,1mm, ausgelegt ist.

Bevorzugt sind auch Ausführungsformen der Erfindung, bei denen ein pneumatisches Probenwechselsystem zum Zuführen und Abführen eines MAS-Rotors zum MAS-Stator vorgesehen ist, welches ebenfalls zur Automatisierung der Messvorbereitungen beiträgt. Bei Weiterbildungen dieser Ausführungsformen kann der pneumatische Antrieb der Verschlussvorrichtung mit derselben Druckluftversorgung wie das pneumatische Probenwechselsystem betrieben werden um die Anlage kompakter und kostengünstiger zu gestalten.

Bevorzugt ist schließlich auch eine Ausführungsform, bei der der MAS-Stator zur Einstellung des MAS-Winkels drehbar gelagert ist. Durch die Drehbarkeit des Stators im Probenkopf kann bei begrenztem Raum das Ein- und Ausführen des MAS-Rotors weiter erleichtert werden; enge Kurven werden vermieden.

Durch die Drehbarkeit des Stators kann zum Ein- und Ausschleusen der Winkel der Stator-Lagerachse gegenüber der Längserstreckungsrichtung des Rohres (die regelmäßig zumindest in guter Näherung der Richtung des statischen Magnetfelds im NMR-Magneten entspricht) verglichen mit dem magischen Winkel verkleinert werden. Von besonderem Vorteil ist es, wenn der MAS-Stator zur Fein-Einstellung des MAS-Winkels in einem Winkelbereich $\Delta\beta \leq \pm 0,5°$, insbesondere $\Delta\beta \leq \pm 0,2°$, vorzugsweise $\Delta\beta \leq \pm 0,1°$, drehbar gelagert ist.

In den Rahmen der vorliegenden Erfindung fällt auch eine NMR-MAS-Messanordnung mit einem erfindungsgemäßen Probenkopf der oben beschriebenen Art, die auch ein NMR-Magnetsystem und gegebenenfalls ein Shimsystem sowie einen Kryostaten umfassen kann.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert.

Es zeigen:

Fig. 1 eine grob-schematische Darstellung einer Ausführungsform des erfindungsgemäßen Probenkopfs im Vertikalschnitt;

Fig. 2a eine schematische Querschnittsdarstellung durch den Stator-Rotor-Bereich eines erfindungsgemäßen NMR-MAS-Probenkopfs in der Beladeposition des MAS-Stators;

Fig. 2b      wie Fig. 2a, jedoch in der Messposition des MAS-Stators;

Fig. 3a      eine schematische, vergrößerte Darstellung des Bereichs zwischen dem oberen Ende des Lichtleiters und einem durch einen Luftspalt von diesem getrennten Lichtleiter-Stummel bei einem erfindungsgemäßen Probenkopf; und

Fig. 3b      eine schematische, vergrößerte Darstellung eines an seinem Lichtleiter-seitigen Ende speziell angeschliffenen Lichtleiter-Stummels.

Die vorliegende Erfindung befasst sich mit dem einer speziell modifizierten Probenkopf für ein NMR-MAS-Spektrometer, bei welcher keine mechanischen Verschiebungen und auch keine zusätzlichen bewegten Bauteile für eine berührungsfreie, sichere Erkennung der aktuellen Bestückung des verschwenkbaren MAS-Stators -also für eine Anwesenheitsdetektion des MAS-Rotors im MAS-Stator- mehr erforderlich sind. Ein solches NMR-MAS-Spektrometer weist in der Regel einen temperierbaren Probenkopf in einer NMR-Messanordnung auf, die ein NMR-Magnetsystem, ein Shimsystem, eine Turbine sowie eine Vorrichtung zum Transport eines MAS-Rotors mit einer Messprobe von außerhalb des NMR-Magnetsystems bis in die Messposition des MAS-Rotors im NMR-Probenkopf umfasst.

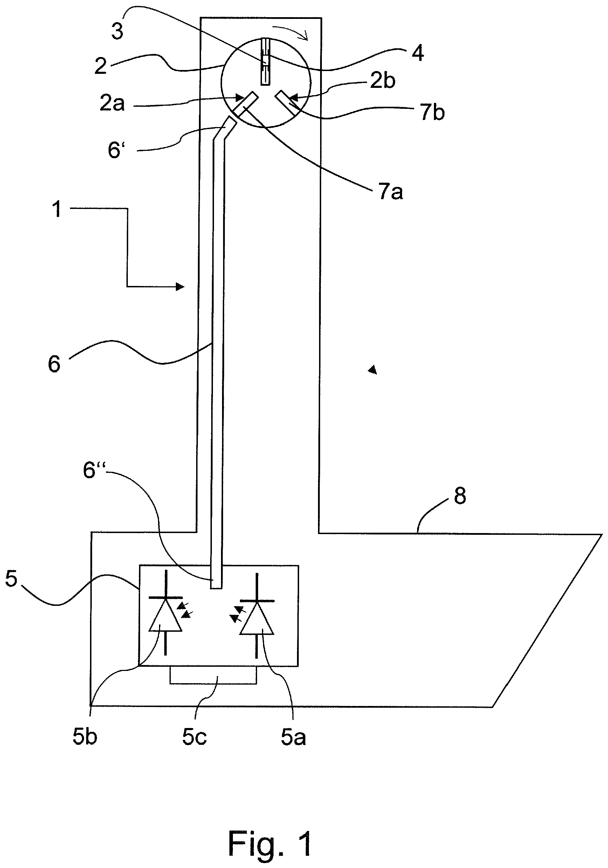

Die **Figur 1** zeigt einen erfindungsgemäßen **NMR-MAS-Probenkopf 1** in einer vertikalen Schnittebene. Wie in Fig. 1 dargestellt, umfasst der erfindungsgemäße Probenkopf 1 einen **MAS-Stator 2** zur Aufnahme eines **MAS-Rotors 3,** welcher in einer Messposition, in der die Zylinderachse des MAS-Rotors 3 im magischen Winkel zu einem Bo-Feld der NMR-MAS-Anordnung steht, in Rotation versetzt werden kann. Der MAS Stator 2 weist eine **Öffnung 4** zur Einführung eines MAS-Rotors 3 auf und ist im NMR-MAS-Probenkopf 1 derart angeordnet, dass er zwischen der Messposition und einer Beladeposition, in welcher ein MAS-Rotor 3 in den MAS-Stator 2 eingeführt werden kann, verschwenkbar ist.

Die vorliegende Erfindung zeichnet sich gegenüber herkömmlichen Anordnungen nach dem Stand der Technik dadurch aus, dass der erfindungsgemäße Probenkopf 1 -wie ebenfalls in Fig. 1 schematisch dargestellt- eine **Detektionsvorrichtung 5** aufweist, die es ermöglicht, berührungslos von außen zu erkennen, ob der MAS-Stator 2 aktuell mit einem MAS-Rotor 3 bestückt ist oder nicht, dass die Detektionsvorrichtung 5 eine **Lichtquelle 5a** aufweist, aus welcher Licht in ein **unteres Ende 6"** eines **Lichtleiters 6** eingeleitet werden kann, und dass der MAS-Stator 2 eine **erste Bohrung 2a** aufweist, in der ein **erster Lichtleiter-Stummel 7a** so positioniert ist, dass er in der Beladeposition des MAS-Stators 2 eine optische Verbindung zwischen einem im MAS-Stator 2 eingeführten MAS-Rotor 3 und einem dem unteren Ende 6" entgegengesetzten **oberen Ende 6'** des Lichtleiters 6 herstellt.

Dadurch wird sicher vermieden, dass mechanischer Stress auf den Lichtleiter 6 ausgeübt wird. Somit ist der Probenkopf 1 im Dauerbetrieb auch bei häufigerem Wechsel der Messproben (also der MAS-Rotoren 3) weit weniger anfällig für Ausfälle aufgrund eines defekten Lichtleiters.

Der Lichtleiter 6 kann an einem Tragegerüst des Probenkopfes 1 befestigt sein. Dadurch ist der Lichtleiter 6 noch besser vor mechanischen Stress geschützt und ist von weiteren elektronischen Bauteilen räumlich getrennt.

Die Detektionsvorrichtung 5 der gezeigten Ausführungsform ist einem **Fußkasten 8** untergebracht und weist einen **lichtempfindlichen Detektor 5b** auf, welcher durch den MAS-Rotor 3 reflektiertes Licht aus dem unteren Ende 6" des Lichtleiters 6 detektieren kann. Außerdem ist eine **Auswerteeinheit 5c** vorgesehen, welche die Signale des lichtempfindlichen Detektors 5b auswerten und damit feststellen kann, ob der MAS-Stator 2 aktuell mit einem MAS-Rotor 3 bestückt ist oder nicht.

Der MAS-Stator 2 in dieser Ausführungsform weist eine **zweite Bohrung 2b** auf, in der ein **zweiter Lichtleiter-Stummel 7b** so positioniert ist, dass er in der Messposition des MAS-Stators 2 jedes Mal eine optische Verbindung zwischen einer **optischen Markierung 9** im MAS-Stator 2 rotierenden MAS-Rotors 3 und dem oberen Ende 6' des Lichtleiters 6 herstellt, wenn die optische Markierung 9 des rotierenden MAS-Rotors 3 am oberen Ende 6' des Lichtleiters 6 vorbeibewegt wird.

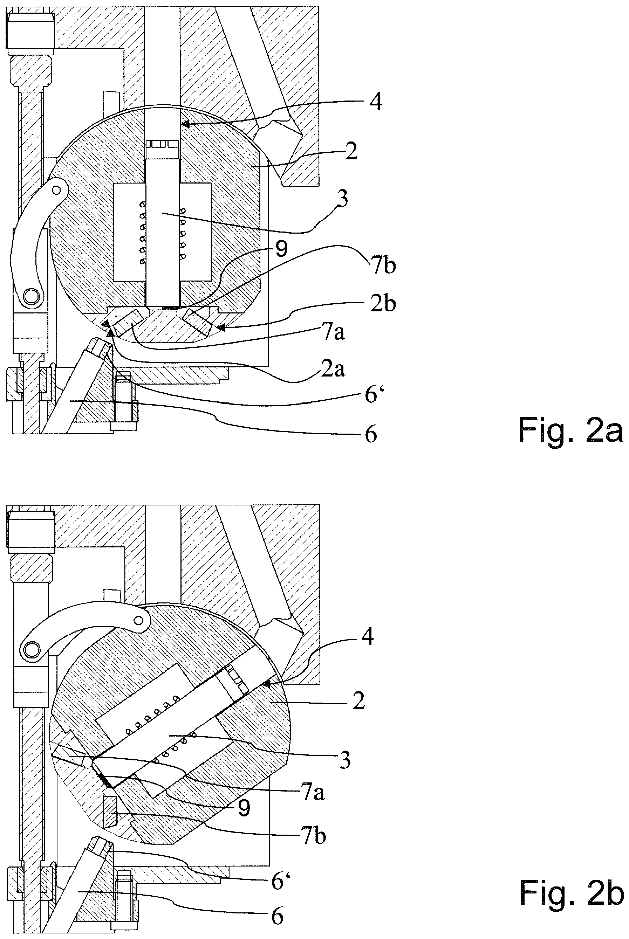

Die **Figuren 2a und 2b** stellen einen -bei vertikal angeordneten NMR-Systemen vertikalen- Querschnitt des oberen Endes einer Ausführungsform des erfindungsgemäßen Probenkopfes 1 in größerem Detail dar.

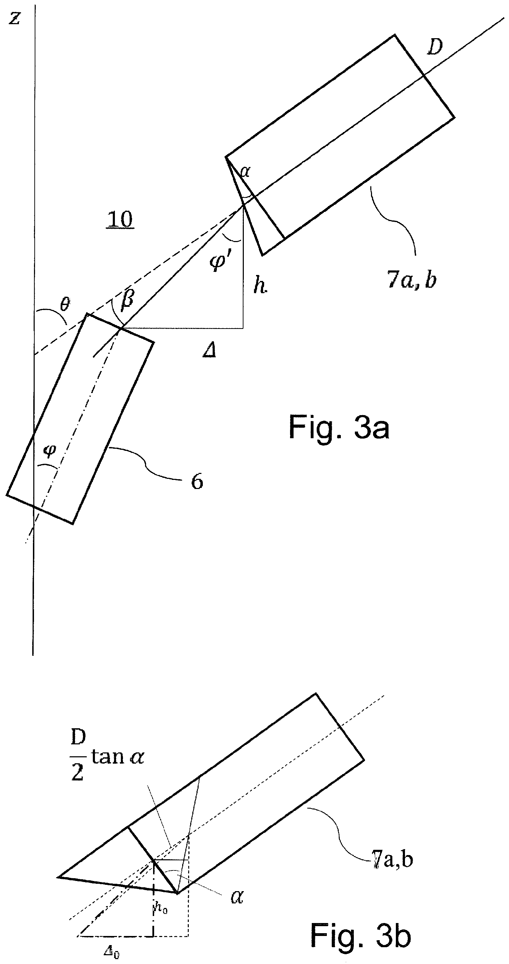

In der in **Fig. 2a** gezeigten Beladeposition zeigt die Öffnung 4 im MAS-Stator 2 senkrecht nach oben, also im 0° Winkel zur z-Achse der NMR-Anordnung. Der erste Lichtleiter-Stummel 7a kann in dieser Position eine optische Verbindung zwischen MAS-Rotor 3 durch den ersten Lichtleiter-Stummel 7a über einen -in Fig. 3a in noch größerem Detail dargestellten- **Luftspalt 10** hin zum Lichtleiter 6 schließen. In dieser Lage ist es möglich, den Beladungszustand des MAS-Stators 2 berührungsfrei optisch zu detektieren. Dies geschieht durch Reflektion eines von der Lichtquelle 5a der Detektionsvorrichtung 5 ausgesandten Lichtstrahls am MAS-Rotor 3, wobei das reflektierte Licht zurück zur Detektionsvorrichtung 5 über den dargestellten Lichtweg geführt wird.

In der in **Fig. 2b** gezeigten Messposition ist der MAS-Stator 2 so verdreht, dass der MAS-Rotor 3 auf den magischen Winkel von 54.74° zur z-Achse gebracht ist. In dieser Messposition wird die optische Verbindung über den zweiten Lichtleiter-Stummel 7b vom MAS-Rotor 3 zur Detektionsvorrichtung 5 über den Luftspalt 10 und den Lichtleiter 6 geschlossen, wodurch eine Messung der Rotationsgeschwindigkeit des MAS-Rotors 3 während des NMR-Messbetriebs ermöglicht wird. Dies geschieht über die herkömmlichen Wege durch die optische Markierung 9 eines Teils des MAS-Rotors 3. Die Auswerteeinheit 5c der Detektionsvorrichtung 5 wandelt dann die empfangenen, zeitlich variierenden Lichtsignale in eine Zählrate um, die wiederum der aktuellen Rotationsfrequenz des MAS-Rotors 3 entspricht.

Der verschwenkbare MAS-Stator 2 ist derart mechanisch gehalten, dass er aus der Messposition in die Beladeposition um einen Verschwenkwinkel $\gamma \geq 3°$, vorzugsweise $\gamma > 35°$, bewegt werden kann.

Die beiden Figuren 2a und 2b zusammen veranschaulichen, wie der MAS-Stator 2 in die beiden Positionen, also die Beladeposition und die Messposition, verschwenkbar ist. Gleichzeitig ist der optische Kontakt der beiden Lichtleiter-Stummel 7a, 7b zum oberen Ende 6' des Lichtleiters 6 in der jeweiligen Position zu erkennen.

Diese Figuren zeigen auch eine besonders bevorzugte Ausführung der erfindungsgemäßen Vorrichtung, in welcher nämlich der Mittelpunkt des MAS-Rotors 3 auch gleichzeitig die Drehachse für die Verschwenkbewegung ist. Die Detektion des Beladungszustands kann direkt aufgrund der Messung von Lichtreflektionen bei im MAS-Stator 2 eingeführtem MAS-Rotor 3 erfolgen. Eine Messung der Rotationsgeschwindigkeit erfolgt mit Hilfe der optischen Markierung 9 am Boden oder an der Bodenkappe des MAS-Rotors.

Wenn die Lichtleiter-Stummel 7a, 7b in einem Winkel zueinander orientiert sind, wobei dieser Winkel genau dem Verdrehwinkel des MAS-Stators 2 entspricht, so ist es möglich, dass der Strahlengang senkrecht vom Lichtleiter-Stummel 7a bzw. 7b durch den Luftspalt 10 hin zum starren Lichtleiter 6 führt. Wenn beispielsweise ein Beladezustand von 0° (senkrechte Beladung des Rotors) gewählt wird und anschließend in die Messposition um den magischen Winkel geschwenkt wird, so könnten die beiden Lichtleiter-Stummel 7a, 7b in einem Winkel von 54,74° zueinander angeordnet sein, wenn diese auf das Drehzentrum des MAS-Stators 2 zeigen. In diesem Fall verläuft der Strahlengang senkrecht durch den Luftspalt 10.

Üblicherweise wird jedoch der Statormittelpunkt als Drehachse gewählt und der Rotormittelpunkt ist zentral im Bo -Feld. Die oben beschriebene Konstellation wäre nur dann realisierbar, wenn die Markierung zur optischen Detektion in der Mitte des Rotors angebracht wäre. Daher ist bei einer besonders bevorzugten Ausführungsform der Erfindung gemäß der **Figuren 3a und 3b** der Lichtleiter-Stummel 7a, 7b mit einem schrägen Schliff in einem Winkel $\alpha$ relativ zur Mittelachse des Lichtleiter-Stummels versehen. Die Abschrägung dient dazu, den Lichtstrahl im Übergang durch den Luftspalt 10 in Richtung des Lichtleiters 6 zu brechen, sodass er möglichst mit maximaler Intensität übertragen wird.

Der Übergang eines Lichtstrahls durch Medien mit unterschiedlichen Brechungsindizes (z.B. Luft, Lichtleitermaterial) folgt dem Brechungsgesetz. Im Beispiel der Zeichnung folgt für vorgegebene Werte $h,\Delta$:

$$\varphi'=\arctan \Delta/h \qquad \text{und} \qquad \beta+\varphi'= \theta+ \alpha$$

$$\alpha=\arcsin (\sin\beta/n\alpha),$$

wobei $n\alpha$ der Brechungsindex des Lichtleitermaterials ist und der Brechungsindex von Luft $n= 1$ ist.

Bei 4mm MAS sollten folgende Werte vorgegeben werden:

| | |
|---|---|
| ø LWL-Adapter | $l$=1.5 $mm$ |
| Initialoffset lateral | $\Delta0$=0.77 $mm$ |
| Initialoffset vertikal | $h0$=0.95 $mm$ |
| Magischer Winkel | 54.74° |
| Brechungsindex (Kern) | $n$=1.62 |
| Schliffwinkel | $\alpha$**=18.8°** |
| Winkel des LWLs | $\varphi$=27.37°=$MA$/2 |
| Winkel des LWL-Adapters | $\theta$=54.37° |

Der Schliffwinkel ist also abhängig vom Brechungsindex des Lichtleiters, vom Drehwinkel des Stators und von der Anordnung der beiden Lichtleiterstummel. Die Toleranz des Schliffwinkels würde umgerechnet auf eine Genauigkeit der Offsets von 5% einem Wertebereich von $\pm$ 30$\mu$m entsprechen, was in der Praxis gut einzuhalten ist. Der Toleranzbereich könnte dann 5% betragen. Grundsätzlich gilt, dass der Schliffwinkel derart ausgelegt ist, dass der ausgesendete und empfangene Lichtstrahl möglichst auf die optische Achse von Lichtleiter und Lichtleiterstummel übertragen wird.

Durch den Schliff kann man auch erreichen, dass die beiden Stummel nicht unbedingt in demselben Winkel zum Rotor stehen müssen, denn mit einem unterschiedlichen Schliff kann die Lichtleitung über den Luftspalt entsprechend angepasst werden.

Bezugszeichenliste:

| | |
|---|---|
| 1 | Probenkopf |
| 2 | MAS-Stator |
| 2a | erste Bohrung |
| 2b | zweite Bohrung |
| 3 | MAS-Rotor |
| 4 | Öffnung zur Einführung eines MAS-Rotors in den MAS-Stator |
| 5 | Detektionsvorrichtung |
| 5a | Lichtquelle |
| 5b | lichtempfindlicher Detektor |
| 5c | Auswerteeinheit |
| 6 | Lichtleiter |

6' oberes Ende des Lichtleiters
6" unteres Ende des Lichtleiters
7a erster Lichtleiter-Stummel
7b zweiter Lichtleiter-Stummel
8 Fußkasten
9 optische Markierung
10 Luftspalt
$\alpha$ Schliffwinkel des Lichtleiterstummels
$\beta$ Winkelabweichung des Strahlengangs von der longitudinalen Achse des Lichtleiterstummels
$\theta$ Winkel zwischen der longitudinalen Achse des Lichtleiterstummels und der z-Achse
$\varphi$ Winkel zwischen der longitudinalen Achse des Lichtleiters und der z-Achse
$\varphi'$ Winkel zwischen der z-Achse und dem Strahlengang im Medium zwischen Lichtleiter und Lichtleiterstummel
$\Delta$ Horizontaler Versatz zwischen dem Eintrittspunkt des Lichtleiters und des Lichtleiterstummels
$\Delta_0$ Horizontaler Versatz zwischen dem Austrittspunkt des Lichtleiters und des Lichtleiterstummels
h Vertikaler Versatz zwischen dem Eintrittspunkt des Lichtleiters und des Lichtleiterstummels
$h_0$ Vertikaler Versatz zwischen dem Austrittspunkten des Lichtleiters und des Lichtleiterstummels
D Durchmesser des Lichtleiterstummels

Referenzliste:

Für die Beurteilung der Patentfähigkeit in Betracht gezogene Publikationen:

[1] DE 10 2013 201 110 B3

[2] EP 3 093 679 B1

[3] DE 10 2014 201 076 B3

[4] US 7,915,893 B2

[5] US 2010 / 0 097 060 A1

**Patentansprüche**

1. Probenkopf (1) einer NMR-MAS-Anordnung mit einem MAS-Stator (2) zur Aufnahme eines MAS-Rotors (3), welcher in einer Messposition, in der die Zylinderachse des MAS-Rotors (3) im magischen Winkel zu einem Bo-Feld der NMR-MAS-Anordnung steht, in Rotation versetzt werden kann, wobei der MAS Stator (2) eine Öffnung (4) zur Einführung eines MAS-Rotors (3) aufweist, wobei der MAS-Stator (2) im NMR-MAS-Probenkopf (1) derart angeordnet ist, dass er zwischen der Messposition und einer Beladeposition, in welcher ein MAS-Rotor (3) in den MAS-Stator (2) eingeführt werden kann, verschwenkbar ist,

**dadurch gekennzeichnet,**
**dass** der NMR-MAS-Probenkopf (1) eine Detektionsvorrichtung (5) aufweist, die es ermöglicht, berührungslos von außen zu erkennen, ob der MAS-Stator (2) aktuell mit einem MAS-Rotor (3) bestückt ist oder nicht,
**dass** die Detektionsvorrichtung (5) eine Lichtquelle (5a) aufweist, aus welcher Licht in ein unteres Ende (6") eines Lichtleiters (6) eingeleitet werden kann, und
**dass** der MAS-Stator (2) eine erste Bohrung (2a) aufweist, in der ein erster Lichtleiter-Stummel (7a) so positioniert ist, dass er in der Beladeposition des MAS-Stators (2) eine optische Verbindung zwischen einem im MAS-Stator (2) eingeführten MAS-Rotor (3) und einem dem unteren Ende (6") entgegengesetzten oberen Ende (6') des Lichtleiters (6) herstellt.

2. Probenkopf nach Anspruch 1, **dadurch gekennzeichnet, dass** die Detektionsvorrichtung (5) einen lichtempfindlichen Detektor (5b) aufweist, welcher durch den MAS-Rotor (3) reflektiertes Licht aus dem unteren Ende (6") des Lichtleiters (6) detektieren kann.

3. Probenkopf nach Anspruch 2, **dadurch gekennzeichnet, dass** eine Auswerteeinheit (5c) vorgesehen ist, welche die Signale des lichtempfindlichen Detektors (5b) auswerten und damit feststellen kann, ob der MAS-Stator (2) aktuell mit einem MAS-Rotor (3) bestückt ist oder nicht.

4. Probenkopf nach einem der vorhergehenden Ansprüche, **dadurch gekennzeichnet, dass** der verschwenkbare MAS-Stator (2) derart mechanisch gehaltert ist, dass er aus der Messposition in die Beladeposition um einen Verschwenkwinkel $\gamma \geq 3°$, vorzugsweise $\gamma > 35°$, bewegt werden kann.

5. Probenkopf nach einem der vorhergehenden Ansprüche, **dadurch gekennzeichnet, dass** der MAS-Stator (2) eine zweite Bohrung (2b) aufweist, in der ein zweiter Lichtleiter-Stummel (7b) so positioniert ist, dass er in der Messposition des MAS-Stators (2) jedes Mal eine optische Verbindung zwischen einer optischen Markierung (9) im MAS-Stator (2) rotierenden MAS-Rotors (3) und dem oberen Ende (6') des Lichtleiters (6) herstellt, wenn die optische Markierung (9) des rotierenden MAS-Rotors (3) am oberen Ende (6') des Lichtleiters (6) vorbeibewegt wird.

6. Probenkopf nach den Ansprüchen 3 und 5, **dadurch gekennzeichnet, dass** der lichtempfindliche Detektor (5b) der Detektionsvorrichtung (5) durch die optische Markierung (9) des MAS-Rotors (3) reflektiertes, am unteren Ende (6") des Lichtleiters (6) ankommendes Licht detektieren kann, und dass die Auswerteeinheit (5c) die Signale des lichtempfindlichen Detektors (5b) auswerten und aufgrund ihrer periodischen Zeitabhängigkeit feststellen kann, mit welcher Frequenz der MAS-Rotor (3) aktuell rotiert.

**7.** Probenkopf nach Anspruch 5 oder 6, **dadurch gekennzeichnet, dass** die beiden Lichtleiter-Stummel (7a, 7b) eine zylindrische Form haben und ihre Zylinderachsen in einem Winkel zueinander orientiert sind, der vorzugsweise dem maximalen Verschwenkwinkel $\gamma$ des MAS-Stators (2) aus der Messposition in die Beladeposition entspricht.

**8.** Probenkopf nach einem der Ansprüche 5 bis 7, **dadurch gekennzeichnet, dass** die Lichtleiter-Stummel (7a, 7b) eine zylindrische Form haben, wobei ihr im beladenen Betriebszustand dem MAS-Rotor (3) zugewandtes eine Ende rechtwinklig zu ihrer Zylinderachse und ihr dem Lichtleiter (6) zugewandtes anderes Ende unter einem Winkel $\alpha$ schräg zu ihrer Zylinderachse plan geschliffen ist.

**9.** Probenkopf nach Anspruch 8, **dadurch gekennzeichnet, dass** der Winkel $\alpha$ abhängig vom Brechungsindex des Lichtleiter-Stummels (7a, 7b) sowie vorzugsweise vom maximalen Verschwenkwinkel $\gamma$ des MAS-Stators (2) aus der Messposition in die Beladeposition gewählt ist.

**10.** Probenkopf nach einem der Ansprüche 8 oder 9, **dadurch gekennzeichnet, dass** die Herstellungstoleranz des Winkels $\alpha$ höchstens 5% beträgt.

**11.** Probenkopf nach einem der Ansprüche 5 bis 7 sowie einem der Ansprüche 8 bis 10, **dadurch gekennzeichnet, dass** im beladenen Betriebszustand dem MAS-Rotor (3) die Zylinderachsen der beiden Lichtleiter-Stummel (7a, 7b) jeweils in einem unterschiedlichen Winkel zur Zylinderachse des MAS-Rotors (3) im MAS-Stator (2) angeordnet sind.

**12.** Probenkopf nach einem der vorhergehenden Ansprüche, **dadurch gekennzeichnet, dass** der Mittelpunkt des MAS-Stators (2) die Drehachse für die Verschwenkung des MAS-Stators (2) bildet, und dass sich der Mittelpunkt des MAS-Rotors (3) zentral im Bo-Feld der NMR-MAS-Anordnung befindet.

**13.** Probenkopf nach einem der vorhergehenden Ansprüche, **dadurch gekennzeichnet, dass** zwischen dem oberen Ende (6') des Lichtleiters (6) und dem ihm zugewandten Ende des ersten Lichtleiter-Stummels (7a) in der Beladeposition des MAS-Stators (2) sowie dem ihm zugewandten Ende des zweiten Lichtleiter-Stummels (7b) in der Messposition des MAS-Stators (2) jeweils ein Luftspalt (10) vorhanden ist, dessen Größe vorzugsweise zwischen 0,1mm und 2mm beträgt.

**Claims**

**1.** A probe head (1) of an NMR-MAS assembly comprising a MAS stator (2) for receiving a MAS rotor (3), which can be set in rotation in a measuring position in which the cylinder axis of the MAS rotor (3) is at the magic angle to a $B_0$ field of the NMR-MAS assembly, wherein the MAS stator (2) has an opening (4) for inserting a MAS rotor (3), wherein the MAS stator (2) is arranged in the NMR-MAS probe head (1) in such a way that it can be pivoted between the measuring position and a loading position, in which a MAS rotor (3) can be inserted into the MAS stator (2),
**characterized in that**
the NMR-MAS probe head (1) has a detection device (5) which makes it possible to contactlessly identify from outside whether or not the MAS stator (2) is currently fitted with a MAS rotor (3),
**in that** the detection device (5) has a light source (5a), from which light can be introduced into a lower end (6") of a light guide (6), and
**in that** the MAS stator (2) has a first bore (2a), in which a first light guide stump (7a) is positioned such that, in the loading position of the MAS stator (2), it produces an optical connection between a MAS rotor (3) inserted in the MAS stator (2) and an upper end (6') of the light guide (6) opposite the lower end (6").

**2.** The probe head as claimed in claim 1, **characterized in that** the detection device (5) has a light-sensitive detector (5b) which can detect light, from the lower end (6") of the light guide (6), reflected by the MAS rotor (3).

**3.** The probe head as claimed in claim 2, **characterized in that** an analysis unit (5c) is provided which can analyze the signals of the light-sensitive detector (5b) and can thus determine whether or not the MAS stator (2) is currently fitted with a MAS rotor (3).

**4.** The probe head as claimed in any one of the preceding claims, **characterized in that** the pivotable MAS stator (2) is held mechanically in such a way that it can be moved from the measuring position into the loading position through a pivot angle $\gamma \geq 3°$, preferably $\gamma > 35°$.

**5.** The probe head as claimed in any one of the preceding claims, **characterized in that** the MAS stator (2) has a second bore (2b), in which a second light guide stump (7b) is positioned such that, in the measuring position of the MAS stator (2), it produces an optical connection between an optical marking (9) of the MAS rotor (3) rotating in the MAS stator (2) and the upper end (6') of the light guide (6) each time the optical marking (9) of the rotating MAS rotor (3) is moved past the upper end (6') of the light guide (6).

**6.** The probe head as claimed in claims 3 and 5, **characterized in that** the light-sensitive detector (5b) of the detection device (5) can detect light reflected by the optical marking (9) of the MAS rotor (3) and reaching the lower end (6") of the light guide (6), and **in that** the analysis unit (5c) can analyze the signals of the light-sensitive detector (5b) and, on the basis of the periodic time dependency thereof, can determine the frequency at which the MAS rotor (3) is currently rotating.

**7.** The probe head as claimed in claim 5 or 6, **characterized in that** the two light guide stumps (7a, 7b) have a cylindrical shape and their cylinder axes are oriented at an angle to one another that preferably corresponds to the maximum pivot angle $\gamma$ of the MAS stator (2) from the measuring position into the loading position.

**8.** The probe head as claimed in any one of the claims 5 to 7, **characterized in that** the light guide stumps (7a, 7b) have a cylindrical shape, wherein their one end facing the MAS rotor (3) in the loaded operating state is ground flat at a right angle to their cylinder axis and their other end, facing the light guide (6), is ground flat at an angle $\alpha$ obliquely to their cylinder axis.

**9.** The probe head as claimed in claim 8, **characterized in that** the angle $\alpha$ is selected depending on the refractive index of the light guide stump (7a, 7b) and preferably on the maximum pivot angle $\gamma$ of the MAS stator (2) from the measuring position into the loading position.

**10.** The probe head as claimed in any one of claims 8 and 9, **characterized in that** the production tolerance of the angle $\alpha$ is at most 5%.

**11.** The probe head as claimed in any one of claims 5 to 7 and any one of claims 8 to 10, **characterized in that** in the loaded operating state of the MAS rotor (3), the cylinder axes of the two light guide stumps (7a, 7b) are each arranged at a different angle to the cylinder axis of the MAS rotor (3) in the MAS stator (2).

**12.** The probe head as claimed in any one of the preceding claims, **characterized in that** the center point of the MAS stator (2) forms the axis of rotation for the pivoting of the MAS stator (2), and **in that** the center point of the MAS rotor (3) is arranged centrally in the $B_0$ field of the NMR-MAS assembly.

**13.** The probe head as claimed in any one of the preceding claims, **characterized in that** an air gap (10) is provided in each case between the upper end (6') of the light guide (6) and the end, facing said light guide upper end, of the first light guide stump (7a) in the loading position of the MAS stator (2), and also the end, facing said light guide upper end, of the second light guide stump (7b) in the measuring position of the MAS stator (2), the size of said air gap preferably being between 0.1 mm and 2 mm.

**Revendications**

**1.** Tête de mesure (1) d'un dispositif RMN-MAS comportant un stator MAS (2) destiné à recevoir un rotor MAS (3) qui peut mis en rotation dans une position de mesure dans laquelle l'axe de cylindre du rotor MAS (3) est à l'angle magique par rapport à un champ $B_0$ de l'ensemble RMN-MAS, le stator MAS (2) présentant une ouverture (4) pour l'introduction d'un rotor MAS (3), le stator MAS (2) étant disposé dans la tête de mesure RMN-MAS (1) de manière à pouvoir pivoter entre la position de mesure et une position de chargement dans laquelle un rotor MAS (3) peut être introduit dans le stator MAS (2), **caractérisée en ce que** la tête de mesure RMN-MAS (1) présente un dispositif de détection (5) qui permet de détecter sans contact de l'extérieur si le stator MAS (2) est actuellement équipé d'un rotor MAS (3) ou non, **que** le dispositif de détection (5) présente une source de lumière (5a) à partir de laquelle de la lumière peut être introduite dans une extrémité inférieure (6") d'un guide de lumière (6) et **que** le stator MAS (2) présente un premier alésage (2a) dans lequel un premier tronçon de guide de lumière (7a) est positionné de telle sorte que, dans la position de chargement du stator MAS (2), il établit une liaison optique entre un rotor MAS (3) introduit dans le stator MAS (2) et une extrémité supérieure (6') du guide de lumière (6) opposée à l'extrémité inférieure (6").

**2.** Tête de mesure selon la revendication 1, **caractérisée en ce que** le dispositif de détection (5) présente un détecteur photosensible (5b) capable de détecter la lumière réfléchie par le rotor MAS (3) provenant de l'extrémité inférieure (6") du guide de lumière (6).

**3.** Tête de mesure selon la revendication 2, **caractérisée en ce qu'**il est prévu une unité d'évaluation (5c) capable d'évaluer les signaux du détecteur photosensible (5b) et ainsi de déterminer si le stator MAS (2) est actuellement équipé d'un rotor MAS (3) ou non.

**4.** Tête de mesure selon l'une des revendications précédentes, **caractérisée en ce que** le stator MAS pivotant (2) est maintenu mécaniquement de manière à pouvoir être déplacé de la position de mesure dans la position de chargement d'un angle de pivo-

tement $\gamma \geq 3°$, de préférence $\gamma > 35°$.

5. Tête de mesure selon l'une des revendications précédentes, **caractérisée en ce que** le stator MAS (2) présente un deuxième alésage (2b) dans lequel un deuxième tronçon de guide de lumière (7b) est positionné de telle sorte que, dans la position de mesure du stator MAS (2), il établit à chaque fois une liaison optique entre une marque optique (9) du rotor MAS (3) en rotation dans le stator MAS (2) et l'extrémité supérieure (6') du guide de lumière (6) lorsque la marque optique (9) du rotor MAS en rotation (3) passe devant l'extrémité supérieure (6') du guide de lumière (6).

6. Tête de mesure selon les revendications 3 et 5, **caractérisée en ce que** le détecteur photosensible (5b) du dispositif de détection (5) peut détecter la lumière réfléchie par la marque optique (9) du rotor MAS (3) et arrivant à l'extrémité inférieure (6") du guide de lumière (6), et que l'unité d'évaluation (5c) peut évaluer les signaux du détecteur photosensible (5b) et, sur la base de leur dépendance temporelle périodique, déterminer à quelle fréquence le rotor MAS (3) tourne actuellement.

7. Tête de mesure selon l'une des revendications 5 ou 6, **caractérisée en ce que** les deux tronçons de guide de lumière (7a, 7b) ont une forme cylindrique et leurs axes de cylindre sont orientés l'un par rapport à l'autre selon un angle qui correspond de préférence à l'angle de pivotement maximal $\gamma$ du stator MAS (2) de la position de mesure vers la position de chargement.

8. Tête de mesure selon l'une des revendications 5 à 7, **caractérisée en ce que** les tronçons de guide de lumière (7a, 7b) ont une forme cylindrique, leur extrémité tournée vers le rotor MAS (3) à l'état de fonctionnement chargé étant rectifiée plane perpendiculairement à leur axe de cylindre et leur autre extrémité tournée vers le guide de lumière (6) obliquement selon un angle $\alpha$ par rapport à leur axe de cylindre.

9. Tête de mesure selon la revendication 8, **caractérisée en ce que** l'angle $\alpha$ est choisi en fonction de l'indice de réfraction du tronçon de guide de lumière (7a, 7b) ainsi que, de préférence, de l'angle de pivotement maximal $\gamma$ du stator MAS (2) de la position de mesure vers la position de chargement.

10. Tête de mesure selon l'une des revendications 8 ou 9, **caractérisée en ce que** la tolérance de fabrication de l'angle $\alpha$ est au maximum de 5 %.

11. Tête de mesure selon l'une des revendications 5 à 7 et l'une des revendications 8 à 10, **caractérisée**

**en ce que**, à l'état de fonctionnement chargé du rotor MAS (3), les axes de cylindre des deux tronçons de guide de lumière (7a, 7b) sont disposés respectivement selon un angle différent par rapport à l'axe de cylindre du rotor MAS (3) dans le stator MAS (2).

12. Tête de mesure selon l'une des revendications précédentes, **caractérisée en ce que** le centre du stator MAS (2) forme l'axe de rotation pour le pivotement du stator MAS (2), et que le centre du rotor MAS (3) se trouve au centre du champ $B_0$ du dispositif RMN-MAS.

13. Tête de mesure selon l'une des revendications précédentes, **caractérisée en ce qu'**entre l'extrémité supérieure (6') du guide de lumière (6) et l'extrémité du premier tronçon de guide de lumière (7a) tournée vers elle dans la position de chargement du stator MAS (2) ainsi que l'extrémité du deuxième tronçon de guide de lumière (7b) tournée vers elle dans la position de mesure du stator MAS (2), il existe chaque fois un espace d'air (10) dont la grandeur est de préférence comprise entre 0,1 mm et 2 mm.

# Fig. 1

Fig. 2a

Fig. 2b

$$\frac{D}{2}\tan\alpha$$

Fig. 3a

Fig. 3b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013201110 B3
- US 20100097060 A1
- EP 3093679 B1
- DE 102014201076 B3
- US 7915893 B2